# EUROPEAN PATENT APPLICATION

(11) **EP 4 113 721 A1**
(43) Date of publication of application: **04.01.2023**
(21) Application number: 21183437.9
(22) Date of filing: 02.07.2021
(51) Int. Cl.: H01M 50/213, H01M 50/249, H01M 50/271, H01M 50/289, H01M 50/505, H01M 50/509, H01M 50/516

(54) **LOW PROFILE BATTERY MODULE**

(71) Applicant: Rimac Automobiles Ltd., 10431 Sveta Nedelja (HR)
(72) Inventor: Pavlovic, Ivan, 10000 Zagreb (HR); Kisic, Daniel, 10450 Jastrebarsko (HR)
(74) Representative: Hoffmann Eitle

(57) **Abstract**

A high voltage battery module comprising a plurality of low voltage battery assemblies, each in turn comprising a plurality of cells with two poles at opposing ends and arranged laterally next to each other so that a pole of a cell is next to a pole of a neighbouring cell; a cell holder arranged on one side of the plurality of laterally arranged cells so as to position the cells at a mutual distance within a given tolerance; and a plurality of interconnectors connecting a pole of one cell to a pole of a neighbouring cell, the battery module further comprising a connection bar at one end of the low voltage battery assemblies so as to connect a pole of an end cell of a first low voltage battery assembly to a pole of end cell of a second low voltage battery assembly, and a pair of terminals at the opposing end of the low voltage battery assemblies providing a high voltage of the battery module.

## Description

### Technical field

The present invention relates to battery modules that hold a plurality of cells. The present invention relates specifically to battery modules that provide electric power to electric vehicles such as electric cars.

### Background

Electric vehicles are experiencing an increased popularity as they gradually replace or complement conventional vehicles with combustion type engines. Vehicles that employ electric motors as the means of drive and propulsion of course require on board electric power that can be generated by electric power sources (for example combustion engines and generators in so-called hybrid vehicles or fuel cells in hydrogen-powered vehicles). An important role, however, play of course batteries for the main storage or at least for buffering and short-time storage purposes. Usually, a relatively large capacity is desirable.

Such on-board power storages are composed of one or more battery modules that, in turn, comprise a plurality of battery cells. The individual cells are usually cylindrical cells in which a layered configuration of electrodes and electrolytes are rolled up so as to provide a large internal interaction surface. An individual cell provides a nominal cell voltage which is typically in the range of 2.5 Volts to 4.2 Volts, depending on chemistry and charging and degradation state of the battery cell. Besides, there are of course not only electrolyte-type battery cells, such as Lithium-ion batteries, but also solid state type battery cells that however incorporate a similar or related chemistry. Nevertheless, individual battery cells feature usually a cylindrical or slab-like housing regardless of the chemistry or physics employed. Further, the individual battery cells provide a relatively low voltage usually far below 10 volts, so that several cells are connected in series to provide the target voltage required in the vehicle.

It is thus clear that battery modules for electrically powered vehicles need to incorporate a substantial number of individual cells that are connected in series and, in respective sets, in parallel, in order to provide the required voltage and power. Usually, a number of cylindrical cells are arranged in an array of upright oriented cells. This configuration allows not only a dense packing but also a convenient way for interconnection in order to attain the required series and parallel connections between and amongst cells. However, this conventional configuration has a minimum height that is governed by the height or length of an individual cell, although a cell in principle features much more miniature dimensions in other directions. The overall height of a battery module may however pose problems when considering the arrangement of the modules inside the vehicle and/or when considering the height of the vehicle's centre of gravity.

There is therefore a need for improved battery modules that allow for space-efficient mounting inside the vehicle and for contributing to lowering a vehicle's centre of gravity, and/or lowering the vehicle's roofline and/or improving aerodynamics whilst maintaining the electrical performance figures, such as voltage, current, power, and capacity.

### Summary

The mentioned problems and drawbacks are addressed by the subject matter of the independent claims. Further preferred embodiments are defined in the dependent claims. Specifically, the embodiments of the present invention may provide substantial benefits that are described in part herein.

According to one aspect of the present invention there is provided a high voltage battery module comprising a plurality of low voltage battery assemblies, each in turn comprising a plurality of cells with two poles at opposing ends and arranged laterally next to each other so that a pole of a cell is next to a pole of a neighbouring cell; a cell holder arranged on one side of the plurality of laterally arranged cells so as to position the cells at a mutual distance within a given tolerance; and a plurality of interconnectors connecting a pole of one cell to a pole of a neighbouring cell, the battery module further comprising a connection bar at one end of the low voltage battery assemblies so as to connect a pole of an end cell of a first low voltage battery assembly to a pole of end cell of a second low voltage battery assembly, and a pair of terminals at the opposing end of the low voltage battery assemblies providing a high voltage of the battery module.

According to one aspect of the present invention there is provided a method of manufacturing a high voltage battery module comprising forming a plurality of low voltage battery assemblies, each forming comprising in turn the steps of providing a cell holder adapted to position a plurality of cells, each with two poles at opposing ends, at a mutual distance within a given tolerance; arranging the plurality of cells laterally on one side of said cell holder and next to each other so that a pole of a cell is next to a pole of a neighbouring cell; connecting a pole of a cell to a pole of a neighbouring cell with one of a plurality of interconnectors, the method further comprising providing of a connection bar at one end of the low voltage battery assemblies, connecting a pole of an end cell of a first low voltage battery assembly to a pole of an end cell of a second low voltage battery assembly, and providing a pair of terminals at the opposing end of the low voltage battery assemblies providing a high voltage of the battery module.

### Brief description of the drawings

Embodiments of the present invention, which are presented for better understanding the inventive concepts but which are not to be seen as limiting the invention, will now be described with reference to the figures in which:
- Figures 1A to 1C: show schematic top views of high voltage battery modules according to respective embodiments of the present invention;
- Figures 2A and 2B: show schematic views of high voltage battery module according to an embodiment of the present invention;
- Figures 3A and 3B: show schematic views of high voltage battery modules with an emphasis on respective cell holders according to embodiments of the present invention;
- Figure 4A and 4B: show details in conjunction with interconnectors according to respective embodiments of the present invention; and
- Figure 5: shows a flowchart of a general method embodiment of the present invention.

### Detailed description

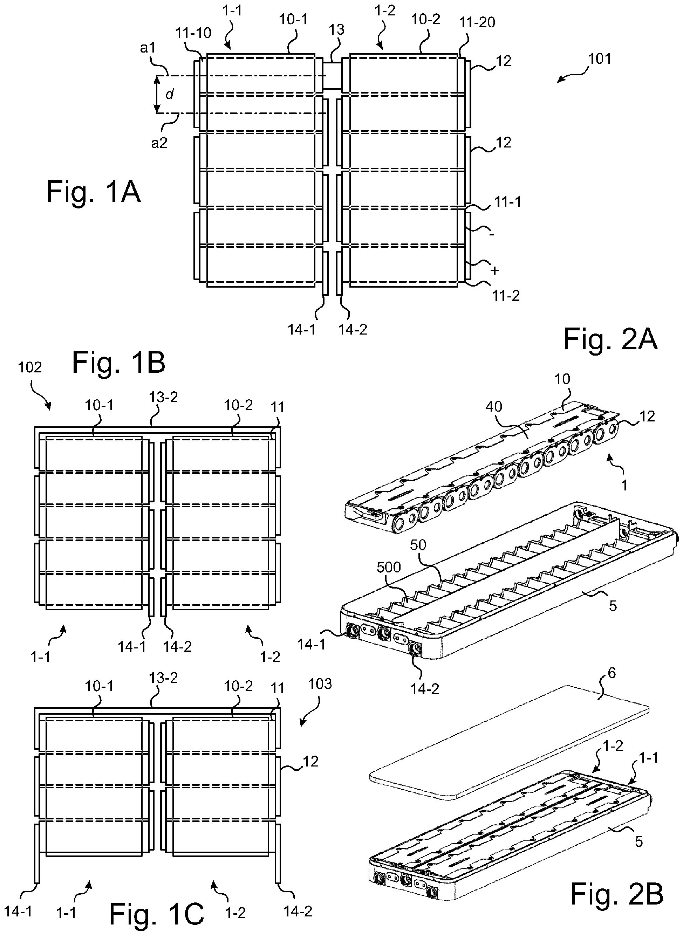

Figure 1A shows a schematic top view of a high voltage battery module according to an embodiment of the present invention. Specifically, there is shown a high voltage battery module 101 that comprises a plurality of low voltage battery assemblies in the form of a first low voltage battery assembly 1-1 and a second first low voltage battery assembly 1-2. The terms high voltage and low voltage respectively are to be understood to be in a relative context so that a high voltage is high as compared to the low voltage. Generally, each low voltage battery assembly 1-1, 1-2 comprises a plurality of cells 12 with two poles +, - at opposing ends of cell 11.

A series connection within a low voltage battery assembly may provide a nominal assembly voltage that equals the nominal voltage of an individual cell 11 multiplied by the number of cells in one assembly, wherein this nominal assembly voltage is identified as a (relatively) low voltage, whilst a series connection of several low voltage battery assemblies then yields the (relatively) high nominal module voltage of the high voltage battery module 101. The individual cells 11 are arranged laterally next to each other so that a pole of a first polarity - of a cell 11-1 is next to a pole of a second polarity + of a neighbouring cell 11-2. In the module 101 such an arrangement may be alternately repeated in one direction so that a series connection of several cells 11 can be achieved by respective interconnections at the side although the individual cells are arranged in a row only next to each other.

The first and second low voltage battery assemblies 1-1, 1-2 each comprise a respective cell holder 10-1, 10-2 that are arranged at least on one side of the plurality of laterally arranged cells 11 so as to position the cells 11 at a mutual distance d within a given tolerance δ. The distance d may be defined as a distance between the main axes a1, a2 of neighbouring cells 11. In this way, there can be obtained a well-defined spacing between two neighbouring cells if the distance considers a tolerance of the diameter or lateral extension of an individual cell 11. In this way, a minimum distance and spacing between neighbouring cells can be obtained so as to avoid any electrical connections or shorts in case the cells do have a housing that is electrically connected to one of the poles. The tolerance δ of the distance d, however, may serve the purpose of positioning the respective centres of the individual cells 11 relative to each other in order to ensure a sufficiently precise fit to interconnectors 12 arranged on lateral sides of the battery assembly 10-1, 10-2.

Namely, the first and second low voltage battery assemblies 1-1, 1-2 each comprise a plurality of such interconnectors 12 that connect a pole of the first polarity + to a pole of the second polarity - of neighbouring cells, thus implementing a series connection of the connected cells. The battery module 101 further comprises at least one connection bar 13 at one end of the low voltage battery assemblies 10-1, 10-2 so as to connect a pole of the first polarity of an end cell 11-10 of the first low voltage battery assembly 10-1 to a pole of the second polarity of an end cell 11-20 of the second low voltage battery assembly 10-2. The battery module 101 further comprises a pair of terminals 14-1, 14-2 at the opposing end of the low voltage battery assemblies 10-1, 10-2 providing a high voltage of the batter module 101.

In the shown embodiment, the cells 11 are arranged so that the poles to be interconnected by the connection bar 13, and the poles leading to pair of terminals 14-1, 14-2 face each other. This embodiment may provide the additional advantage of a further reduced overall module length through the connection of the facing poles at one end and a narrow positioning of the terminals 14-1, 14-2, which may in turn be advantageous with regard to mounting a connector for connecting the module to other modules or to a power supply bar or chain.

Figures 1B and 1C show schematic top views of high voltage battery modules according to respective embodiments of the present invention. Like numbers as in the description in conjunction with Fig. 1A are used and the respective explanations apply likewise. In Figure 1B there is shown an embodiment, in which the cells of the module 102 are arranged so that the busbar 13-2 connects the poles of the end cells 11-10 and 11-20 at each respective outer end. In Figure 1C there is shown an embodiment, in which additionally the cells of the module 103 are arranged so that also the terminals 14-1, 14-2 are arranged at each respective outer end. The latter may provide the advantage that entire modules 103 may be again connected in series, wherein then the terminals to be interconnected face each other and are located relatively close to each other. Also, there may be a combination of the arrangements of figures 1A and 1C envisaged. Further, the shown number of individual cell per each assembly and module is only for illustrative purposes and can be set according to the respective overall voltage, current, and capacity requirements.

In the so far shown embodiments, the plurality of cells are arranged laterally next to each other so that a pole of a first polarity of a cell is next to a pole of a second polarity of a neighbouring cell, and said plurality of interconnectors connect a pole of the first polarity to a pole of the second polarity of neighbouring cell. Further, the connection bar connects a pole of the first polarity of an end cell of a first low voltage battery assembly to a pole of the second polarity of an end cell of a second low voltage battery assembly. In summary, this corresponds to a series connection of the cells.

However, there are well envisaged embodiments in which there is - at least partly - parallel connection of the cells, in which two or more cells are connected so that their poles of the same polarity are connected in a parallel connection fashion. Generally, thus, the present invention provides a plurality of cells with two poles at opposing ends and arranged laterally next to each other so that a pole of a cell is next to a pole of a neighbouring cell and a plurality of interconnectors connecting a pole of one cell to a pole of a neighbouring cell. A connection bar at one end of the low voltage battery assemblies can connect a pole of an end cell of a first low voltage battery assembly to a pole of end cell of a second low voltage battery assembly, and a pair of terminals at the opposing end of the low voltage battery assemblies providing a high voltage of the battery module. Therefore, the low voltage battery assemblies can provide serial, serial and parallel or only a parallel connection of the cells, and the connection bar can connect the assemblies in series or again in parallel.

Figures 2A and 2B show schematic views of high voltage battery module according to an embodiment of the present invention. Similarly as before, there is shown a low voltage battery assembly 1 in turn comprising a plurality of cells and a plurality of interconnectors 12 connecting a pole of one cell to a pole of a neighbouring cell. The cells are arranged laterally next to each other so that a pole of a cell is next to a pole of a neighbouring cell. A cell holder 10 is arranged on one side of the plurality of laterally arranged cells so as to position the cells at a mutual distance within a given tolerance. Further, there may be arranged a printed circuit board 40 as shown and described in greater detail elsewhere in the present disclosure.

In this embodiment, the battery module further comprises a module housing 5 having an opening through which the plurality of low voltage battery assemblies 1 can be inserted so that said cell holder 10 at least in part covers the opening. A further cell holder 50 can be arranged on an opposing side of the cell holder 10. Optionally, said further cell holder 50 is formed by a bottom of said module housing 5 by means of a plurality of neighbouring recesses 500. The module can comprise a plurality of fixation points in between individual cells of the low voltage battery assemblies. Optionally, the plurality of fixation points are arranged on an external side of the recessed bottom of the module housing between two neighbouring recesses. In Figure 2B there is shown additionally a cover lid 6 atop the cell holder closing the opening of the module housing 5 which may further comprise a seal between said cover lid 6 and the opening of the module housing 5.

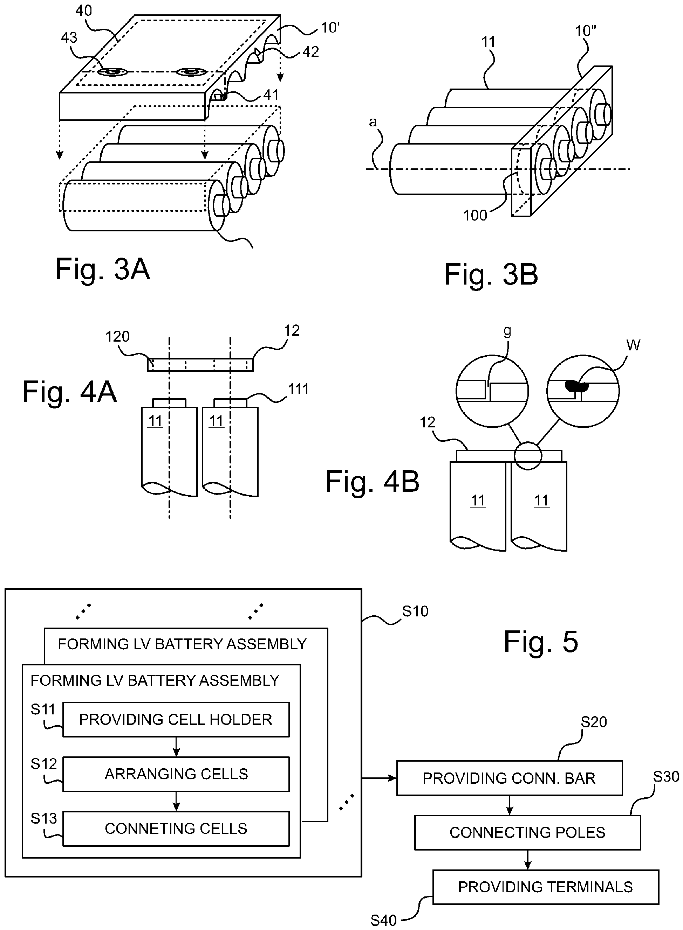

Figures 3A and 3B show schematic views of high voltage battery modules with an emphasis on respective cell holders according to embodiments of the present invention. In Figure 3A there is shown a cell holder 10' arranged on one lateral side of the plurality of laterally arranged cells 11 so as to position the cells at a mutual distance within a given tolerance. In this embodiment, the cell holder 10' can be a part that can be put over the battery cells 11 so as to ensure the relative position (as shown), or the cells may 11 be laid into a cell holder 10' that is accordingly flipped upside down.

Optionally, the cell holder 10' may comprise, incorporate or embed a printed circuit board 40 that in turn comprises connectors leading to temperature sensors 41 and/or voltage detection points 42. In respective embodiments, there are arranged a plurality of voltage sensing connectors 42 on said cell holder 10' and/or there are arranged a plurality of temperature sensors 41 on said cell holder 10'. The arrangement of voltage sensing connectors in the cell holder may allow for voltage detection along cell holder in a linear arrangement. Further, the linear arrangement may allow good temperature sensing of every cell along cell holder. In a further embodiment, a plurality of fixation points 43 are arranged in the cell holder 10' in between individual cells 11 which allows for an efficient use of the space between cylindrical individual cells.

In Figure 3B there is shown a cell holder 10" arranged on the side of the plurality of laterally arranged cells 11 so as to position the cells at a mutual distance within a given tolerance. Specifically, the cell holder 10" can provide bores 100 and, optionally, a reduction or abatement that holds the cells 11 also in a direction along the main cell axis a. A further cell holder such as the one 10" may be provided on the other end of the cells so as to hold them at both ends.

Figure 4A and 4B show details in conjunction with interconnectors according to respective embodiments of the present invention. Specifically, there is shown a pair of cells with respective pole protrusions 111 that are to be interconnected by an interconnector 12. As shown, the interconnector 12 provides fitting bores 120 that are arranged to fit adequately to the pole protrusions 111 of each cell 11 to be interconnected. The interconnector may be made of a suitable metal material that allows interconnection to the pole protrusion 111 for example by means of welding. For example, the metal may be aluminium or an appropriate alloy thereof that allows for welding and high current carriage capacities, i.e. low electrical resistance.

In Figure 4B there is shown a state in which the interconnector 12 was mounted to the cells 11. In the left inset there is shown a gap g formed between the inner wall of the bore 112 and the outer wall of the pole protrusion 111 of the cell 11. It is clear that the gap g shall meet all requirements on positioning and welding, so that the material is close enough to flow together when weld heated by, for example, a laser. In the right inset there is shown a weld W that can extend along the entire circumference of the pole protrusion so as to form a contact with a low as possible electrical resistance.

At this point it should be noted that the cell holders as provided by the embodiments of the present invention can substantially contribute to positioning the cells, and, with this, forming a well-defined, reproducible and suitable gap g for forming the weld W. Further, the arrangement of the fitting bores still allow for some tolerance along the cell axis a, as a weld W may be still formed even if the top surface of the pole protrusion 111 and the top surface of the interconnector 12 are not precisely level. Rather, a weld W can still be formed even if the protrusion protrudes from the interconnector or is recessed in relation to that. In this way, again the cell holders as provided by the embodiments of the present invention can align the cells 11 parallel to each other while a allowing a compensation of a length tolerance of the cells 11. In this way a non-parallel arrangement of the cells can be avoided, which, if present, would pose the risk of an unwanted electrical contact of the cell walls that may be connected to one of the poles of a cell.

With the described embodiments the present invention is able to provide substantial improvements in the manufacture of battery modules and the design and likewise manufacture of electric vehicles, such as electric and/or hybrid cars. Specifically, embodiments of the present invention may reduce the height of battery modules in an electric vehicle so as to contribute to reducing the overall vehicle height and lowering the vehicle's centre of gravity, and/or lowering the vehicle's roofline and/or improving aerodynamics. A low module height is achieved by a horizontal cell placement, preferably in one layer. Generally, more layers are envisaged as long as the height of the stacked layers is less than the length of an upright cell. The invention provides with its embodiments high voltage battery module with several single-row low-voltage (LV) assemblies. A busbar can then interconnect the LV assemblies at one end so as to create a HV battery module. Due to the linear chaining of many cells, individual cell tolerances may add up to inacceptable level (for example +/- 1.6 mm, or +/- 1.0 mm which may not allow for reliable cell contacting/welding and/or makes it difficult to meet the requirements on the module tolerances. Embodiments of the invention provide a single sided cell holder that ensures correct positioning of the individual cells and cell contacting whilst keeping height at a minimum.

Figure 5 shows a flowchart of a general method embodiment of the present invention. Specifically, there are shown the steps of a method of manufacturing a high voltage battery module that comprises a step S10 of forming a plurality of low voltage battery assemblies, each forming comprising in turn a step S11 of providing a cell holder adapted to position a plurality of cells, each with two poles at opposing ends, at a mutual distance within a given tolerance; A step S12 of arranging the plurality of cells laterally on one side of said cell holder and next to each other so that a pole of a cell is next to a pole a neighbouring cell; and a step S13 of connecting a pole of a cell to a pole of a neighbouring cell with one of a plurality of interconnectors. The method further comprises a step S20 of providing of a connection bar at one end of the low voltage battery assemblies, a step S30 of connecting a pole of an end cell of a first low voltage battery assembly to a pole of an end cell of a second low voltage battery assembly, and a step S40 of providing a pair of terminals at the opposing end of the low voltage battery assemblies providing a high voltage of the battery module.

Although detailed embodiments have been described, these only serve to provide a better understanding of the invention defined by the independent claims and are not to be seen as limiting.

## Claims

1. A high voltage battery module comprising a plurality of low voltage battery assemblies, each in turn comprising
- a plurality of cells with two poles at opposing ends and arranged laterally next to each other so that a pole of a cell is next to a pole of a neighbouring cell;
- a cell holder arranged on one side of the plurality of laterally arranged cells so as to position the cells at a mutual distance within a given tolerance; and
- a plurality of interconnectors connecting a pole of one cell to a pole of a neighbouring cell,
the battery module further comprising a connection bar at one end of the low voltage battery assemblies so as to connect a pole of an end cell of a first low voltage battery assembly to a pole of end cell of a second low voltage battery assembly, and a pair of terminals at the opposing end of the low voltage battery assemblies providing a high voltage of the battery module.

2. The high voltage battery module according to claim 1, wherein said plurality of cells are arranged laterally next to each other so that a pole of a first polarity of a cell is next to a pole of a second polarity of a neighbouring cell, and wherein said plurality of interconnectors connect a pole of the first polarity to a pole of the second polarity of neighbouring cell.

3. The high voltage battery module according to claim 1 or 2, wherein said connection bar connects a pole of the first polarity of an end cell of a first low voltage battery assembly to a pole of the second polarity of an end cell of a second low voltage battery assembly.

4. The high voltage battery module according to any one of claims 1 to 3, wherein there are arranged a plurality of voltage sensing connectors on said cell holder.

5. The high voltage battery module according to any one of claims 1 to 4, wherein there are arranged a plurality of temperature sensors on said cell holder.

6. The high voltage battery module according to any one of claims 1 to 5, wherein the cell holder comprises a printed circuit board.

7. The high voltage battery module according to any one of claims 1 to 6, further comprising a module housing having an opening through which the plurality of low voltage battery assemblies can be inserted so that said cell colder at least in part covers the opening.

8. The high voltage battery module according to claim 7, further comprising a cover lid atop the cell holder closing the opening of the module housing.

9. The high voltage battery module according to claim 8, further comprising a seal between said cover lid and the opening of the module housing.

10. The high voltage battery module according to any one of claims 7 to 9, wherein the module housing comprises a further cell holder arranged on an opposing side of the cell holder.

11. The high voltage battery module according to claim 10, wherein said further cell holder is formed by a bottom of said module housing by means of a plurality of neighbouring recesses.

12. The high voltage battery module according to any one of claims 1 to 11, further comprising a plurality of fixation points in between individual cells of the low voltage battery assemblies.

13. The high voltage battery module according to claims 11 and 12, wherein the plurality of fixation points are arranged on an external side of the recessed bottom of the module housing between two neighbouring recesses.

14. The high voltage battery module according to any one of claims 1 to 13, wherein a cell has a cylindrical cell housing.

15. A method of manufacturing a high voltage battery module comprising
forming a plurality of low voltage battery assemblies, each forming comprising in turn the steps of
- providing a cell holder adapted to position a plurality of cells, each with two poles at opposing ends, at a mutual distance within a given tolerance;
- arranging the plurality of cells laterally on one side of said cell holder and next to each other so that a pole of a cell is next to a pole of a neighbouring cell;
- connecting a pole of a cell to a pole of a neighbouring cell with one of a plurality of interconnectors,
the method further comprising providing of a connection bar at one end of the low voltage battery assemblies, connecting a pole of an end cell of a first low voltage battery assembly to a pole of an end cell of a second low voltage battery assembly, and providing a pair of terminals at the opposing end of the low voltage battery assemblies providing a high voltage of the battery module.
